# EUROPÄISCHE PATENTANMELDUNG

(11) **EP 0 875 995 A1**
(43) Veröffentlichungstag der Anmeldung: **04.11.1998**
(21) Anmeldenummer: 98107257.2
(22) Anmeldetag: 21.04.1998
(51) Int. Cl.: H03K 19/0175

(54) **Integrierte Datenübertragungsschaltung mit Potentialtrennung zwischen Ein- und Ausgangsschaltkreis**

(30) Priorität: 30.04.1997 DE 19718420
(71) Anmelder: SIEMENS AKTIENGESELLSCHAFT, 80333 München (DE)
(72) Erfinder: Munz, Dieter, Dipl.Ing. (FH), 91315 Höchstadt (DE)

(57) **Zusammenfassung**

Diese enthält einen Eingangsschaltkreis (2) mit einem Eingang (4) für binäre Eingangssignale (24), einen Ausgangsschaltkreis (70) mit einem integrierten, magnetosensitiven Koppelelement (15) und mindestens einem Ausgang (7), der vom Koppelelement angesteuert wird und über den binäre Ausgangssignale (25) abgebbar sind. Ferner sind Leitungsmittel (13,14) vorhanden, womit in einer die Spannungspotentiale im Ein- und Ausgangsschaltkreis trennenden Weise Eingangssignale in die räumliche Nähe des Koppelelementes geleitet werden. Vorteilhaft dient als Koppelelement ein integrierter Hallgenerator.

## Beschreibung

Bei der Übertragung von insbesondere binären Daten ist es häufig notwendig, in der Übertragungsstrecke Potentialtrennungen vorzusehen. Dabei werden die Folgen ankommender binärer Datensignale, welche bezogen auf das Spannungspotentialsystem einer Empfangsschaltung vorliegen, in eine Folgeschaltung übertragen, welche auf ein anderes Spannungspotentialsystem bezogen ist. Die Übertragung der Daten zwischen der Empfangs- und Folgeschaltung muß somit potentialgetrennt erfolgen.

Bislang werden derartige, potentialtrennende Übertragungsschaltungen in einem, aus diskreten Bauelementen bestehenden Schaltungsaufbau realisiert. Die Schaltungen beruhen dabei in der Regel auf dem Prinzip eines Optokopplers, eines induktiven Impulsübertragers oder eines kapazitiven Kopplers. So muß z.B. bei einem Optokoppler zumindest die Sendediode der Potentialtrennungsstrecke als diskretes Bauelement vorhanden sein. Ferner erfordern induktive Impulsübertrager oder kapazitive Koppler ebenfalls u.U. größere induktive oder kapazitive diskrete Bauteile.

Der Erfindung liegt die Aufgabe zugrunde, eine Datenübertragungsschaltung anzugeben, welche vollständig integrierbar und somit in Form eines einzigen Chips realisierbar ist.

Die Aufgabe wird gelöst mit der im Anspruch 1 angegebenen Datenübertragungsschaltung. Weitere, vorteilhafte Ausführungsformen der Erfindung sind in den Unteransprüchen angegeben.

Die Erfindung wird an Hand von in den nachfolgend kurz angeführten Figuren dargestellten Ausführungsbeispielen näher erläutert. Dabei zeigt
- FIG 1 :: das Prinzipschaltbild der erfindungsgemäßen, integrierten Datenübertragungsschaltung,
- FIG 2 :: eine erste Ausführungsform der erfindungsgemäßen, integrierten Datenübertragungsschaltung mit einer steuerbaren Konstantstomquelle im Eingangsschaltkreis, und
- FIG 3 :: eine bevorzugte Ausführungsform der erfindungsgemäßen, integrierten Datenübertragungsschaltung, wobei als magnetosensitives Bauelement ein integrierter Hallgenerator vorgesehen ist.

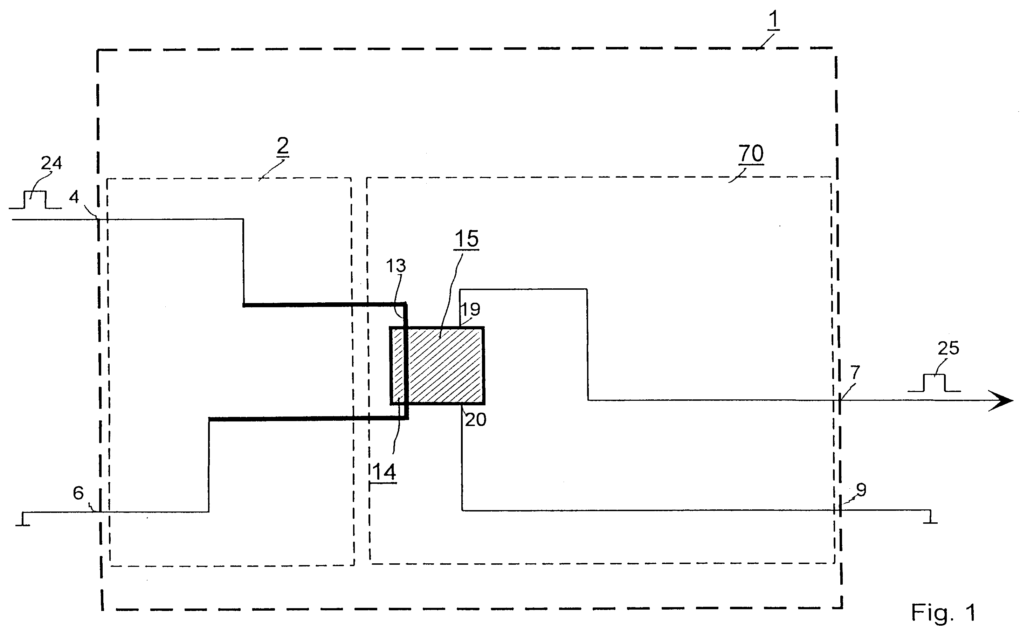

Figur 1 zeigt das Prinzipschaltbild einer gemäß der Erfindung aufgebauten integrierten Datenübertragungsschaltung 1. Diese enthält einen integrierten Eingangsschaltkreis 2 mit mindestens einem Eingang 4. Diesem sind binäre Eingangssignale zuführbar. Figur 1 zeigt beispielhaft einen Puls 24 eines derartigen Eingangssignales. Die Datenübertragungsschaltung 1 enthält ferner einen integrierten Ausgangsschaltkreis 70. Dieser weist ein integriertes, magnetosensitives Koppelelement 15 auf. Der Ausgang 7 des Ausgangsschaltkreises 70 wird vom magnetosensitiven Koppelelement 15 angesteuert. Hierüber sind binäre Ausgangssignale abgebbar, wobei in Figur 1 wiederum beispielhaft ein Puls 25 eines derartigen Ausgangssignales gezeigt ist.

Erfindungsgemäß sind Leitungsmittel vorhanden, womit in einer, die Spannungspotentiale im Ein- und Ausgangsschaltkreis 2 bzw. 70 trennenden Weise die Eingangssignale 24 oder davon abgeleitete, diesen entsprechende Signale, im Eingangsschaltkreis 2 in die räumliche Nähe des integrierten magnetosensitiven Koppelelementes 15 im Ausgangsschaltkreis 7 geleitet werden. Im Beispiel der Figur 1 werden binäre Eingangssignale 24 über den Eingang 4, eine Leiterschleife bis zum Massepotential am Eingang 6 der Datenübertragungsvorrichtung 1 geleitet. Erfindungsgemäß weist die Leiterschleife ein Leitungssegment 13 auf, welches sich in der räumlichen Nähe des integrierten magnetosensitiven Koppelelementes 15 befindet. Bei dem in Figur 1 dargestellten Beispiel ist die Leiterschleife 13 über das darunter befindliche magnetosensitive Koppelelement 15 gelegt. Eine derartige Anordnung kann beim Aufbau der erfindungsgemäßen Schaltung in integrierter Form z.B. in sogenannter C-MOS Technik dadurch erreicht werden, daß zwischen der Oberseite des integrierten magnetosensitiven Koppelelementes 15 und der Leiterschleife 13 eine Isolierschicht 14 z.B. aus Siliziumdioxid angeordnet ist, wodurch die gewünschte Potentialtrennung zwischen Ein- und Ausgangsschaltkreis 2 und 70 bewirkt wird. Wird ein binärer Datenimpuls 24 in den Eingang 4 des erfindungsgemäßen integrierten Magnetokopplers eingespeist, so bewirkt dessen Stromfluß ein lokales Magnetfeld insbesondere um das Leitungssegment 13. Dieses pulsartige Magnetfeld wird von dem benachbarten magnetosensitiven Koppelelement 15 im Ausgangsschaltkreis erfaßt. Hierdurch wird ein weiterer Signalimpuls ausgelöst, welcher in die beispielhaft vom Ausgang 7 über die beiden Anschlüsse 19, 20 am magnetosensitiven Bauelement 15 bis zum Ausgang 9 reichenden Leiterschleife eingespeist wird. Im Beispiel der Figur 1 erscheint das aktive Potential dieses Signalimpulses 25 am Ausgang 7, während der Ausgang 9 der Datenübertragungsvorrichtung 1 wiederum an einem Massepotential angeschlossen ist.

Die erfindungsgemäße Schaltung hat den Vorteil, daß ein vollständig integrierter Aufbau ohne diskrete Bauelemente möglich ist. Das magnetosensitive Bauelement ermöglicht die Entkopplung von binären Eingangssignalen, welche auf das aktuelle Spannungspotential im Eingangsschaltkreis 2 bezogen sind von den davon abgeleiteten Ausgangssignalen, welche auf das aktuelle Spannungspotential im Ausgangsschaltkreis 7 bezogen sind. So können im Beispiel der Figur 1 die Anschlüsse 6 und 9 der Datenübertragungsschaltung mit unterschiedlichen Massekreisen verbunden sein.

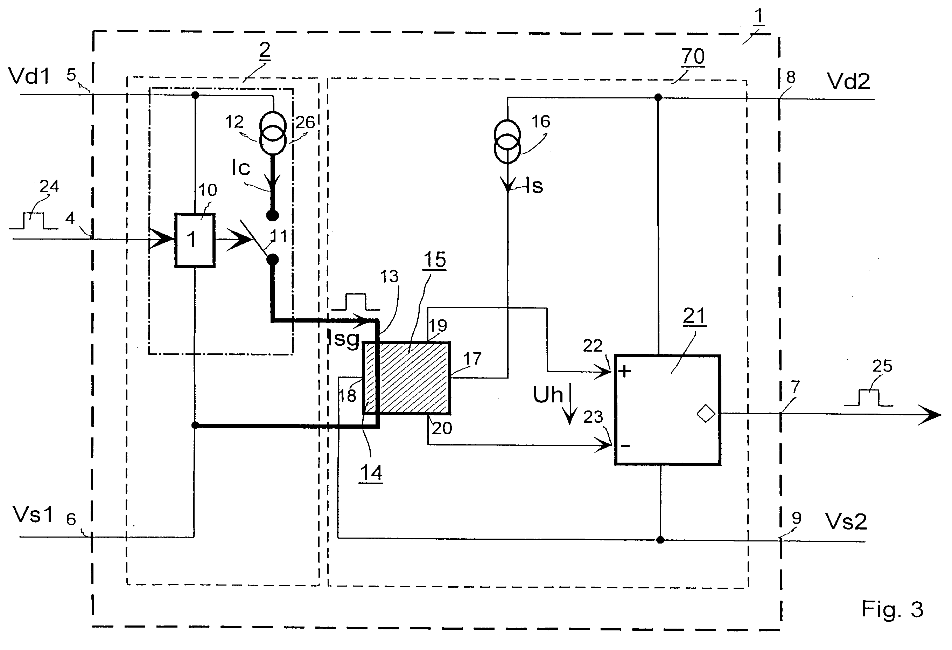

Bevorzugt kann das integrierte magnetosensitive Koppelelement 15 in Form eines integrierten Hallgenerators aufgebaut sein. Eine derartige Ausführung wird nachfolgend am Beispiel der Figur 3 noch näher beschrieben werden. Ferner ist es auch möglich, daß das integrierte magnetosensitive Koppelelement 15 in Form eines sogenannten integrierten anisotropen, magnetosensitiven Bauelements 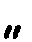 AMR" oder eines sogenannten integrierten giant, magnetosensitiven Bauelements 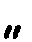 GMR" aufgebaut ist.

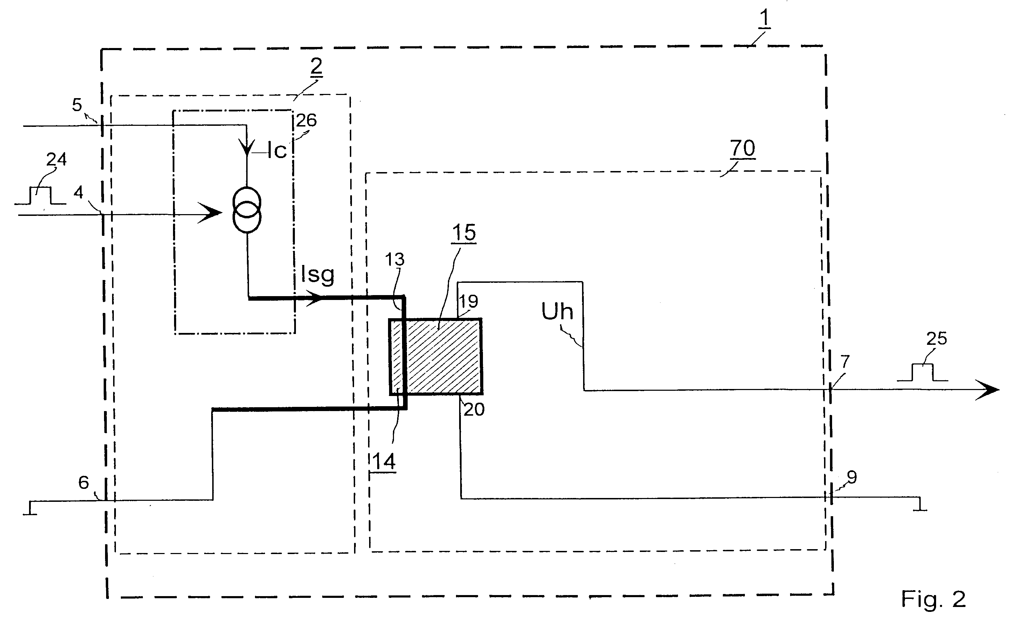

Gemäß einer weiteren, im Beispiel der Figur 2 dargestellten Ausführung kann der integrierte Eingangsschaltkreis 2 der integrierten Datenübertragungsschaltung 1 eine erste, steuerbare Konstantstromquelle 26 aufweisen. Deren Konstantstrom Ic kann bei einer Ausführung im Takt von binären Eingangssignalen 24 am Eingang 4 gesteuert zu- und abgeschaltet werden. In der Leitung 13 treten dann unipolare Pulse auf. Bei einer anderen, in den Beispielen nicht dargestellten Ausführung kann der Konstantstrom durch den Takt der binären Eingangssignale gesteuert auch im Vorzeichen umgeschaltet werden. In der Leitung 13 treten dann bipolare Pulse auf. Hierdurch entsteht ein getakteter Signalstrom Isg, welcher erfindungsgemäß in einer potentialtrennenden Weise wiederum über das Leitungssegment 13 in die räumliche Nähe des integrierten magnetosensitiven Koppelelementes 15 im Ausgangsschaltkreis 7 geleitet wird. Der Signalstrom Isg löst wiederum ein entsprechendes, potentialgetrenntes Ausgangssignal über das magnetosensitive Koppelelement 15 im Ausgangsschaltkreis 70 aus.

In Figur 3 ist schließlich eine bevorzugte Ausführungsform der erfindungsgemäßen, integrierten Datenübertragungsschaltung im Detail dargestellt, wobei als magnetosensitives Bauelement ein integrierter Hallgenerator vorgesehen ist.

Der Eingangsschaltkreis 2 ist dabei auf ein Spannungspotentialsystem bezogen, welches aus einer positiven Versorgungsspannung Vd1 am Eingang 5 und einem Bezugspotential Vs1, insbesondere einem Massepotential, am Eingang 6 besteht. Der Ausgangsschaltkreis 70 ist auf ein anderes Spannungspotentialsystem bezogen, welches aus einer positiven Versorgungsspannung Vd2 am Eingang 8 und einem getrennten Bezugspotential Vs2, insbesondere einem Massepotential, am Eingang 9 besteht.

Bei dem in Figur 3 dargestellten Beispiel der integrierten Datenübertragungsschaltung 1 weist die erste, steuerbare Konstantstromquelle 26 vorteilhaft eine integrierte Konstantstromquelle 12 auf, welche in einer Leiterschleife angeordnet ist, deren Enden an dem Versorgungsspannungspotential Vd1 und dem Bezugsspannungspotential Vs1 angeschlossen sind. Ferner ist das in räumlicher Nähe zum integrierten magnetosensitiven Koppelelement 15 befindliche Leitungssegment 13 ein wesentlicher Bestandteil dieser Leiterschleife. Es ist im Beispiel der Figur 3 in einer verstärkten Linie dargestellt. Das Element 26 umfaßt vorteilhaft zusätzlich einen integrierten, digitalen Treiber 10, dem die binären Eingangssignale 24 zugeführt werden. Dieser wird über entsprechende Anschlüsse ebenfalls von den Potentialen Vd1, Vs1 des ersten Potentialsystems gespeist. Der Treiber 10 taktet ein integriertes Schaltelement 11, welches in Reihe zur integrierten Konstantstromquelle 12 geschaltet ist und aus dem Konstantstrom Ic einen zum Eingangssignal 24 entsprechenden, getakteten Signalstrom Isg abgibt, welcher über das Leitungssegment 13 in der bereits beschriebenen Weise potentialgetrennt auf das magnetosensitive Koppelelement 15 einwirkt.

Die in Figur 3 dargestellte, steuerbare Konstantstromquelle 26 hat den Vorteil, daß damit weitgehend unabhängig vom aktuellen, möglicherweise schwankenden Hub der Eingangssignale 24 in jedem Fall ausreichend große, frequenzgleiche Signalstrompulse Isg an der Potentialtrennstelle zum magnetosensitiven Koppelelement 15 erzeugt werden können, und somit dort fehlerfrei in entsprechende Signalstromketten im Ausgangsschaltkreis umgesetzt werden können.

Bei der in Figur 3 dargestellten Ausführung der integrierten Datenübertragungsschaltung ist das magnetosensitive Koppelelement 15 vorteilhaft in Form eines integrierten Hallelements ausgeführt. Dieses wird über die Anschlüsse 17, 18 mit einem Steuerstrom Is versorgt, welcher Voraussetzung für die Abgabe einer Hallspannung Uh an den Ausgängen 19, 20 ist. Der Steuerstrom wird von einer zweiten Konstantstromquelle 16 bereitgestellt, welche einerseits über den Eingang 8 des integrierten Datenübertragungselementes von der Spannung Vd2 und andererseits über den Eingang 9 von der Spannung Vs2 des zweiten Potentialsystems des Ausgangsschaltkreises 70 gespeist wird. Tritt somit ein von einem binären Eingangssignal 24 hervorgerufener, getakteter Signalstrom Isg auf, so wird im integrierten Hallelement eine potentialgetrennte Hallspannung Uh hervorgerufen. Diese kann als Ausgangssignal direkt an den Ausgang 7 der Datenübertragungsschaltung weitergegeben werden.

Bei der in der Figur 3 dargestellten, vorteilhaften Ausführungsform der Erfindung weist der integrierte Ausgangsschaltkreis 70 weiterhin einen integrierten Digitalkomparator 21 auf, dem die Spannung Uh am Ausgang des integrierten, magnetosensitiven Koppelelementes 15 an den Komparatoreingängen 22 und 23 zugeführt wird. Dies hat den Vorteil, daß über den Ausgang des Digitalkomparators 21 ein zu den Konventionen binärer Logik vollständig konformes binäres Ausgangssignal 25 am Ausgang 7 der Datenübertragungsschaltung abgebbar ist.

## Patentansprüche

1. Integrierte Datenübertragungsschaltung (1), mit
a) einem integrierten Eingangsschaltkreis (2) mit mindestens einem Eingang (4), dem binäre Eingangssignale (24) zuführbar sind,
b) einem integrierten Ausgangsschaltkreis (70), mit
b1) einem integrierten, magnetosensitiven Koppelelement (15), und
b2) mindestens einem Ausgang (7), der vom magnetosensitiven Koppelelement (15) angesteuert wird und über den binäre Ausgangssignale (25) abgebbar sind, und mit
c) Leitungsmitteln (13,14), womit in einer die Spannungspotentiale (Vd1,Vs1;Vd2,Vs2) im Ein- und Ausgangsschaltkreis (2;70) trennenden Weise die Eingangssignale (24) oder entsprechende Signale (Isg) im Eingangsschaltkreis (2) in die räumliche Nähe des integrierten magnetosensitiven Koppelelementes (15) im Ausgangsschaltkreis (70) geleitet werden.

2. Integrierte Datenübertragungsschaltung nach Anspruch 1, wobei der integrierte Eingangsschaltkreis (2)
a) eine erste, steuerbare Konstantstromquelle (26) aufweist, welche einen durch die binären Eingangssignale (24) getakteten Signalstrom (Isg) abgibt, und
b) der getaktete Signalstrom (Isg) in einer potentialtrennenden Weise die räumliche Nähe des integrierten magnetosensitiven Koppelelementes (15) im Ausgangsschaltkreis (70) geleitet wird.

3. Integrierte Datenübertragungsschaltung nach Anspruch 2, wobei die erste, steuerbare Konstantstromquelle (26) aufweist
a) eine integrierte Konstantstromquelle (12),
b) einen integrierten, digitalen Treiber (10), dem die binären Eingangssignale (24) zugeführt werden,
c) ein integriertes Schaltelement (11), welches in Reihe zur integrierten Konstantstromquelle (12) geschaltet ist und von den Signalen am Ausgang des digitalen Treibers (10) getaktet den getakteten Signalstrom (Isg) abgibt.

4. Integrierte Datenübertragungsschaltung nach einem der vorangegangenen Ansprüche, wobei der integrierte Ausgangsschaltkreis (70) einen integrierten Digitalkomparator (21) aufweist, dem die Spannung (Uh) am Ausgang des integrierten, magnetosensitiven Koppelelementes (15) an den Komparatoreingängen (22,23) zugeführt wird, und über dessen Ausgang (7) die binären Ausgangssignale (25) abgebbar sind.

5. Integrierte Datenübertragungsschaltung nach einem der vorangegangenen Ansprüche, wobei das integrierte magnetosensitive Koppelelement (15) in Form eines integrierten Hallgenerators aufgebaut ist.

6. Integrierte Datenübertragungsschaltung nach einem der Ansprüche 1 bis 4, wobei das integrierte magnetosensitive Koppelelement (15) in Form eines integrierten anisotropen, magnetoresisitven Bauelements (AMR) aufgebaut ist.

7. Integrierte Datenübertragungsschaltung nach einem der Ansprüche 1 bis 4, wobei das integrierte magnetosensitive Koppelelement (15) in Form eines integrierten giant, magnetosensitiven Bauelements (GMR) aufgebaut ist.

8. Integrierte Datenübertragungsschaltung nach einem der vorangegangenen Ansprüche, wobei die Datenübertragungsschaltung in C-MOS Technik integriert ist.
